# EUROPEAN PATENT APPLICATION

(11) **EP 3 179 481 A1**
(43) Date of publication of application: **14.06.2017**
(21) Application number: 15830445.1
(22) Date of filing: 03.08.2015
(51) Int. Cl.: G21K 4/00, G01T 1/20

(54) **METHOD FOR MANUFACTURING DISPLAY MEMBER**

(30) Priority: 08.08.2014 JP 2014162146
(71) Applicant: Toray Industries, Inc., Tokyo 103-8666 (JP)
(72) Inventor: FUJIWARA, Hideyuki, Otsu-shi Shiga 520-8558 (JP); ITSUKI, Naohide, Otsu-shi Shiga 520-8558 (JP); TANINO, Takahiro, Otsu-shi Shiga 520-8558 (JP)
(74) Representative: Kador & Partner
(86) International application number: PCT/JP2015/071945
(87) International publication number: WO 2016/021546

(57) **Abstract**

Provided is a method for manufacturing a display member, the method being capable of densely packing a composition, which contains an inorganic material including a phosphor, into cells separated by preformed barrier ribs, without damaging the barrier ribs. The method for manufacturing a display member according to the present invention includes packing a composition, which contains an inorganic material, into cells separated by barrier ribs, under an isostatic pressure.

## Description

### TECHNICAL FIELD

The present invention relates to a method for manufacturing a display member.

### BACKGROUND ART

As a display member in which a composition containing an inorganic material is packed in cells separated by barrier ribs, for example, a plasma display panel of a plasma television etc. and a scintillator panel are known. In particular, the scintillator panel is a constituent element of a digital-type radiation detector such as a flat panel detector (hereinafter, referred to as a "FPD") for medical use, and has been acceleratingly developed in recent years.

For a scintillator panel having barrier ribs, a method has been proposed in which a radiation phosphor being an inorganic material is packed into cells separated by barrier ribs (Patent Documents 1, 2 and 3), or a groove portion is formed in a phosphor, and a barrier rib portion is formed in the groove portion (Patent Document 4). In the scintillator panel, the radiation phosphor emits visible light in response to an applied radiation, and the emitted light is converted into an electric signal by a TFT (thin film transistor) or a CCD (charge-coupled device) to convert information of the radiation into digital image information. Here, the barrier rib serves to inhibit the problem that at the time when the radiation phosphor emits light, visible light is scattered by the radiation phosphor itself, leading to a decrease in S/N ratio. On the other hand, luminance improvement is performance improvement necessary for reducing an exposure dosage for the scintillator, and rather than oxide-based phosphors, phosphors which are semitransparent and have high light extraction efficiency, such as BaFCl: Eu, CsI and NaI, have been put to use. (Patent Document 5)

### PRIOR ART DOCUMENTS

### PATENT DOCUMENTS

Patent Document 1: Japanese Patent Laid-open Publication No. 5-60871
Patent Document 2: Japanese Patent Laid-open Publication No. 2012-002627
Patent Document 3: Japanese Patent Publication No. 5110230
Patent Document 4: Japanese Patent Laid-open Publication No. 2004-317300
Patent Document 5: Japanese Patent Examined Publication No. 59-045022

### SUMMARY OF THE INVENTION

### PROBLEMS TO BE SOLVED BY THE INVENTION

However, a conventional method in which a phosphor is packed into cells separated by preformed barrier ribs has the problem that it is necessary to densely pack the phosphor for further improving the luminance of a scintillator panel, and if a pressure is carelessly applied at the time of packing the phosphor, the barrier ribs are damaged. A method in which a groove portion is formed in a phosphor has the problem that it is difficult to make pixels fine, or a long time is required for forming a groove and forming barrier ribs.

An object of the present invention is to provide a method for manufacturing a display member, the method being capable of densely packing a composition, which contains an inorganic material including a phosphor, into cells separated by preformed barrier ribs, without damaging the barrier ribs.

### SOLUTIONS TO THE PROBLEMS

The object is achieved by any of the following technical means.
(1) A method for manufacturing a display member, the method including packing a composition, which contains an inorganic material, into cells separated by barrier ribs, under an isostatic pressure.
(2) The method for manufacturing a display member according to (1), wherein the barrier rib contains glass as a main component.
(3) The method for manufacturing a display member according to (1) or (2), wherein the display member includes a reflecting layer between the barrier rib and the composition containing an inorganic material, and the reflecting layer contains a metal oxide as a main component.
(4) The method for manufacturing a display member according to any one of (1) to (3), wherein the display member includes a light shielding layer between the barrier rib and the composition containing an inorganic material, and the light shielding layer contains a metal as a main component.
(5) The method for manufacturing a display member according to (3) or (4), wherein the display member includes a protective layer between the reflecting layer and the composition containing an inorganic material or between the light shielding layer and the composition containing an inorganic material.
(6) The method for manufacturing a display member according to any one of (1) to (5), wherein the packing of the composition containing an inorganic material, under the isostatic pressure is performed while the cells and the composition containing an inorganic material are vacuum-packaged.
(7) The method for manufacturing a display member according to any one of (1) to (6), wherein the composition containing an inorganic material is in the form of a thin film, and the composition in the form of a thin film is disposed on the opening surfaces of the cells, and packed.
(8) The method for manufacturing a display member according to (7), wherein the composition in the form of a thin film is obtained by press-molding the composition containing an inorganic material.
(9) The method for manufacturing a display member according to (8), wherein the composition in the form of a thin film is obtained by performing press-molding under an isostatic pressure.
(10) The method for manufacturing a display member according to (9), wherein the press-molding under the isostatic pressure is performed while the composition containing an inorganic material is vacuum-packaged.
(11) The method for manufacturing a display member according to any one of (1) to (10), wherein the inorganic material contains a phosphor.
(12) The method for manufacturing a display member according to (11), wherein the phosphor has plasticity.
(13) The method for manufacturing a display member according to any one of (1) to (12), wherein the display member is a scintillator panel.
(14) A display member obtained by the manufacturing method according to any one of (1) to (13), wherein the packing ratio of the composition containing an inorganic material, which is packed into the cells under the isostatic pressure, is 75% or more.
(15) The display member according to (14), wherein the packing ratio of the composition containing an inorganic material, which is packed into the cells under the isostatic pressure, is 95% or more.
(16) The display member according to (14) or (15), wherein the composition containing an inorganic material is packed in a longitudinally long shape under the isostatic pressure.

### EFFECTS OF THE INVENTION

According to a method for manufacturing a display member according to the present invention, a display member in which a composition containing an inorganic material is packed in cells separated by barrier ribs, such as a high-luminance and high-sharpness scintillator panel, can be provided with a high yield, without damaging the barrier ribs.

### BRIEF DESCRIPTION OF THE DRAWINGS

Fig. 1 is a sectional view schematically showing a configuration of a radiation detector including a scintillator panel.
Fig. 2 is a sectional view schematically showing a configuration of the scintillator panel.
Fig. 3 is a sectional view schematically showing a configuration of the scintillator panel at the start of packing a composition into cells.
Fig. 4 is a sectional view schematically showing a configuration of the scintillator panel just before the end of packing where the composition is almost fully packed into the cells.
Fig. 5 is a sectional view schematically showing a cross-section observation image and a grain shape for the scintillator with the composition packed in the cell.

### EMBODIMENT OF THE INVENTION

A method for manufacturing a display member according to the present invention includes packing a composition, which contains an inorganic material, into cells separated by barrier ribs, under an isostatic pressure.

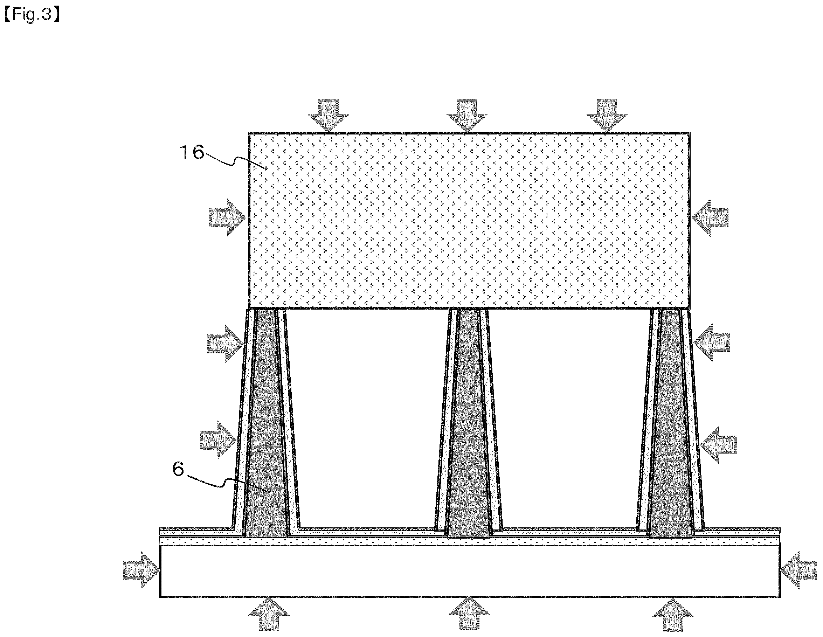

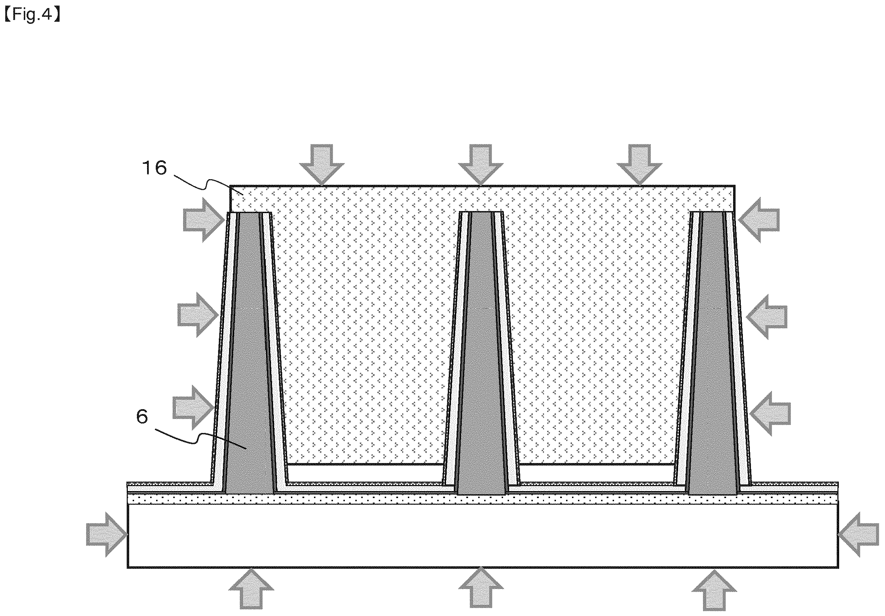

The "isostatic pressure" is a pressure that is equally applied, independently of a position or direction, to a barrier rib surface, and a surface of a composition containing an inorganic material (hereinafter, referred to as a "composition surface"), which is a packed material in the method for manufacturing a display member according to the present invention. Here, the composition surface is a surface, to which a pressure from the outside of cells can be applied, in a composition 16 that is being packed. At the start of packing where the solid composition 16 is placed at the openings of the cells as in, for example, Fig. 3, the composition surface is a surface of the composition exposed to the outside of the cells (surfaces shown by arrows in Fig. 3). Just before the end of packing where the composition 16 is almost fully packed into the cells as in, for example, Fig. 4, the composition surface is a surface of the composition which is visible from the outside of the cells (surfaces shown by arrows in Fig. 4).

The barrier rib surface is a surface, to which a pressure from the outside of cells can be applied, in the barrier rib during packing of the composition. As the pressure that is applied to the composition surface and the barrier rib surface, an isostatic pressure may be applied indirectly to the composition surface and the barrier rib surface via a medium.

Here, the isostatic pressure is applied only to a portion where the composition surface or the barrier rib is in direct contact with the medium. The medium is, for example, a plastic bag capable of collectively packaging the barrier ribs and the composition containing an inorganic material, a gas filled into the plastic bag, or a rubber lump or metal thin film which has high flexibility and shape followability and is capable of covering most of the composition surface.

Rather than a pressure from a specific direction, i.e. a uniaxial pressure, an isostatic pressure is applied to the composition surface and the barrier rib surface, so that damage to the barrier rib can be prevented. Further, an isostatic pressure is applied, so that when the inorganic material has plasticity, the inorganic material is not collapsed to a plate shape, and the wettability thereof is improved. As a result, packing unevenness of the inorganic material can be suppressed, and the luminance can be efficiently improved.

The composition containing an inorganic material is, for example, a single inorganic material, a mixture of a plurality of inorganic materials, or a mixture of the inorganic material(s) and an organic compound. Here, the inorganic material is some carbon compound (graphite etc.) having a simple chemical structure, or a compound composed of elements other than carbon.

When the composition containing an inorganic material is composed of a single inorganic material, and the inorganic material is a lump such as a crystal having a relatively large size, the inorganic material is preferably in the form of a powder or thin film (sheet) which has plasticity. When the single inorganic material is in the form of a powder, the particle size thereof is preferably uniform. The surface of the powder may be coated with a lubricant for improving lubricity between powders. When the single inorganic material is in the form of a thin film, the thickness thereof is preferably uniform.

When the composition containing an inorganic material is a mixture of a plurality of inorganic materials, it is preferable that the composition containing an inorganic material is in the form of a powder or thin film for further improving plasticity, and it is more preferable that the particle size or thickness thereof is uniform. For suppressing packing unevenness and moisture absorption, the composition containing an inorganic material is preferably in the form of a thin film. The method for forming the composition, which contains an inorganic material, into a thin film is, for example, cutting by a wire saw, or press molding. The thickness of the inorganic material in the form of a thin film can be appropriately determined according to the depth of cells separated by barrier ribs, i.e. the height of the barrier rib. When the single inorganic material or the mixture of a plurality of inorganic materials has insufficient plasticity, it is preferable to mix an organic substance such as a binder resin with the inorganic material (s). The mixture may be formed into a thin film, and then packed. The method for forming the mixture into a thin film is, for example, a method in which a thin film of the mixture is formed on a PET film by a die coater etc., and separated from the PET film.

When the display member is a scintillator panel, the composition containing an inorganic material contains a phosphor as the inorganic material. The phosphor is, for example, cesium iodide doped with thallium iodide as a dopant, i.e. CsI:TI, orNaI:Tl, CsI:Na, CsI, CsBr:Eu, SrI₂:Eu, CaI₂:Eu, CsBa₂I5 : Eu, BaFCl:Eu, CdWO₄, CaWO₄, Gd₂O₂S:Tb, Gd₂O₂S:Pr, Gd3Al₂Ga₃O₁₂:Ce, Bi₄Ge₃O₁₂, ZnS:Ag or Y₂O₂S:Tb.

The dopant is used for improving light emission characteristics such as light emission efficiency and persistence characteristics. A dopant that is optimum in view of a combination with a phosphor as a base material is selected, and a plurality of dopants may be used. When the amount of the dopant is excessively low, the effect is reduced, and when the amount of the dopant is excessively high, internal absorption may occur, leading to deterioration of quantum efficiency. Therefore the dopant is used in an optimum concentration for each combination of the base material and the dopant. For example, in the case of CsI:Tl, the concentration of TI is preferably not less than 0.05 wt% and not more than 1 wt%, more preferably not less than 0.1 1 wt% and not more than 0.6 wt%. In the case of SrI₂:Eu, the concentration of Eu is preferably not less than 0.5 wt% and not more than 10 wt%, more preferably not less than 1 wt% and not more than 5 wt%.

When the phosphor has plasticity, an isostatic pressure may be directly applied to the crystal of the phosphor to perform packing. Alkali halide-based phosphors such as CsI:Tl, NaI:Tl and SrI₂: Eu mostly have plasticity, and are therefore preferably used.

On the other hand, when a method in which a phosphor is powdered, or formed into a thin film by performing press molding is employed, unevenness of the luminance within a surface can be suppressed.

As a method for powdering the phosphor, an optimum method is selected according to a phosphor. For an alkali halide-based phosphor such as CsI : TI, a method in which a phosphor obtained by a crystal growth method such as a Czochralski method, a Bridgman method or a vacuum vapor deposition method is powdered by a grinder is preferably used. For an oxide-based phosphor such as Gd₂O₂S: Tb, a method in which a sintered powder is obtained by a high-temperature sintering method, or method in which a phosphor sintered body obtained by a discharge plasma sintering method is powdered by a grinder is preferably used.

When a binder resin and a phosphor are mixed and packed, for example, the binder resin to be mixed is preferably a butyral resin or ethyl cellulose resin which does not significantly absorb light emitted by the phosphor and which is not significantly degraded with time.

Methods for applying an isostatic pressure to a medium situated on the composition surface or the barrier rib surface, or on the outermost side are generally classified into several methods according to a medium to be used, a heating temperature, or the like. Those methods include, for example, a CIP method, a WIP method, a HIP method and a RIP method.

Here, the CIP method (cold isostatic pressing method) is a method in which a liquid such as water is used as a medium, and heating is not performed; the WIP method (warm isostatic pressing method) is a method in which a liquid such as water or silicon oil is used as a medium, and heating is performed at 15 to 200°C; the HIP method (hot isostatic pressing method) is a method in which an argon gas or nitrogen gas is used as a medium, and heating is performed at 15 to 2500°C; and the RIP method (rubber isostatic pressing method; sometimes referred to as a DIP method (disc isostatic pressing method)) is a method in which an elastic body having high flexibility, such as rubber, is used.

In the case of the CIP method or the WIP method, it is preferable that for preventing the composition, which contains an inorganic material, from being contaminated or eroded by water, silicon oil or the like that is one of the media, the barrier ribs and the composition are enclosed in a plastic bag serving as one of the media.

The plastic bag is more preferably one having high heat resistance and confidentiality. Preferably, the plastic bag is one made of polypropylene or nylon. The inside of the plastic bag may be in a vacuum state, or a gas such as air which serves as one of the media may exist in the plastic bag. For improving performance as a display member, the packing ratio in the cell after packing the composition containing an inorganic material is preferably high, i.e. 75% or more. The packing ratio is more preferably 95% or more. When the packing ratio is less than 75%, the amount of the phosphor as a light emission base material decreases, leading to a reduction in luminance. When the packing ratio is 95% or more, the amount of the phosphor as a light emission base material is sufficiently high, and the amount of voids that scatter emitted light, and the amount of impurities decrease, leading to an increase in luminance. For achieving a high packing ratio, it is preferable to bring the inside of the plastic bag into a vacuum state, and the vacuum degree is preferably -90 kPa or lower. The packing ratio of the composition containing an inorganic material can be measured in the following manner: an image of a cross-section vertical to a substrate surface is taken using a scanning electron microscope, a portion of the composition containing an inorganic material and a void portion in the cell are distinguished from each other by binarization, and the ratio of the composition portion is determined by image analysis.

For minimizing a measurement error, image analysis is performed for each of three randomly selected cells, the analysis results for the cells are averaged, and the average thus obtained is defined as a packing ratio of the composition after packing. The grain size at a cross-section is a shape of a grain boundary in the composition containing an inorganic material in the cell, where the shape of the grain boundary is obtained by taking an image of a cross-section vertical to a substrate using a scanning electron microscope or a scanning ion microscope. At a grain boundary, it may be difficult to discriminate the outline of the grain shape with a usual scanning microscope for some materials, but the outline of the grain shape can be clearly discriminated by using an EBSD (electron back scatter diffraction patterns) method.

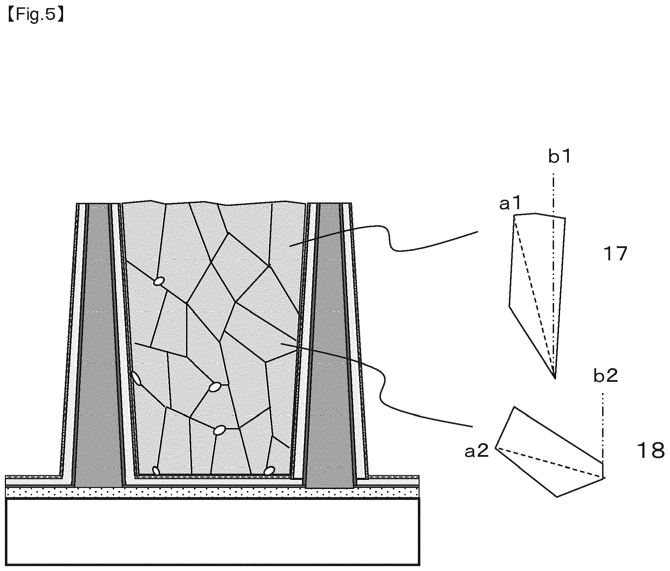

The straight line having the largest length among straight lines between two lines on the outline of the grain shape is defined as a maximum length diameter (line segments a1 and a2 in Fig. 5), and when the angle of the maximum length diameter with respect to a direction vertical to a substrate (line segments b1 and b2 in Fig. 5) is 0° or more and less than 45°, the grain shape is determined to be longitudinal. When the angle of the maximum length diameter with respect to the substrate is not less than 45° and not more than 90°, the grain shape is determined to be lateral. For example, in a longitudinal grain shape 17 in Fig. 5, the angle formed by the line segment a1 and the line segment b1 is 13°, and in a lateral grain shape 18, the angle formed by the line segment a2 and the line segment b2 is 76°. In a grain having a small shape, a measurement error easily occurs, and therefore grain shapes in the cell are determined in descending order from the grain shape having the largest area. When 60% or more of grain shapes in terms of an integrated area are longitudinal, it is determined that the composition is packed in a longitudinal shape.

Preferably, the composition containing an inorganic material is disposed above the opening surface of the cell, and then packed for performing packing more smoothly. The method for disposing an appropriate amount of the composition is, for example, a die coater application method, a spraying method or application by a spatula. When the composition containing an inorganic material is in the form of a powder, the composition may be disposed directly on the opening surface of the cell, but when the composition is formed into a thin film, and then disposed, the packing density can be increased.

The magnitude of the pressure to be applied to the medium situated on the composition surface or the barrier rib surface, or on the outermost side may be appropriately determined according to a viscosity of the composition containing an inorganic material or a density after packing, and for example, when the composition containing an inorganic material is CsI: TI, the pressure to be applied to the medium is preferably 10 to 1000 MPa, more preferably 50 to 500 MPa. When the pressure is low, the porosity in the cell after packing is high, and when the pressure is excessively high, the barrier rib may be warped under a residual pressure with time.

The pressure rise rate is preferably 60 to 400 MPa/minute. When the pressure rise rate is lower than 60 MPa/minute, the composition is not packed smoothly because of friction resistance between the composition containing an inorganic material and the light shielding layer, the reflecting layer or the protective layer, and thus the substrate and the barrier rib may be strained. When the pressure rise rate is higher than 400 MPa/minute, the composition containing an inorganic material is not followably deformed, and thus a load may be applied locally to the substrate and the barrier rib, leading to damage to the substrate and the barrier rib. The pressure fall rate is preferably 500 MPa/minute or less. When the pressure fall rate is higher than 500 MPa/minute, voids in the composition containing an inorganic material and packed in the cell may be ruptured, leading to damage to the substrate and the barrier rib.

It is advantageous that the temperature at which the composition containing an inorganic material is packed in the cell is high to some extent for reducing the viscosity of the composition. When the barrier rib contains glass as a main component, the temperature at which the composition containing an inorganic material is packed in the cell is preferably equal to or lower than the softening point of glass for preventing deformation of the barrier rib. Specifically, the temperature is more preferably 500°C or lower, still more preferably 400°C or lower. When the composition containing an inorganic material contains a binder resin, the temperature at which the composition containing an inorganic material is packed in the cell is preferably equal to or lower than the decomposition temperature of the binder resin.

After the composition containing an inorganic material is packed, an excess composition may be wiped off with a solvent etc., or mechanically abraded. When the thickness of the excess composition is large, emitted light is easily scattered in the horizontal direction of the display member. Therefore, it is preferable that the thickness of the composition is adjusted during packing so that the height of the packed composition is equivalent to the height of the barrier rib, or the excess composition is wiped off with a solvent etc. after packing, or removed by abrading after packing.

Hereinafter, a specific configuration of the display member manufactured by the manufacturing method according to the present invention, where the display member is a scintillator panel, will be described with reference to the drawings, but the present invention is not limited thereto.

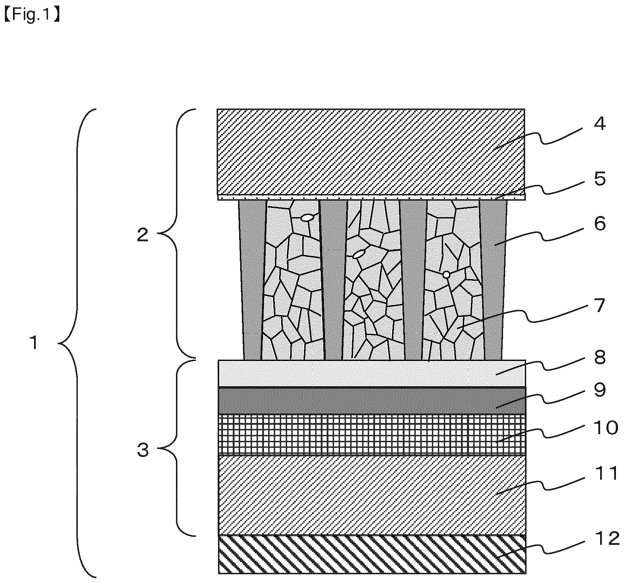

Fig. 1 is a sectional view schematically showing a configuration of a radiation detector including one aspect of the display member, i.e. a scintillator panel, manufactured by the manufacturing method according to the present invention. A radiation detector 1 includes a scintillator panel 2, an output substrate 3 and a power supply unit 12. The scintillator panel 2 includes a phosphor layer 7 containing a phosphor as n inorganic material. The phosphor absorbs energy of an incident radiation, and emits an electromagnetic wave having a wavelength ranging from 300 nm to 800 nm, i.e. an electromagnetic wave (light) ranging from ultraviolet light to infrared light with visible light at the center.

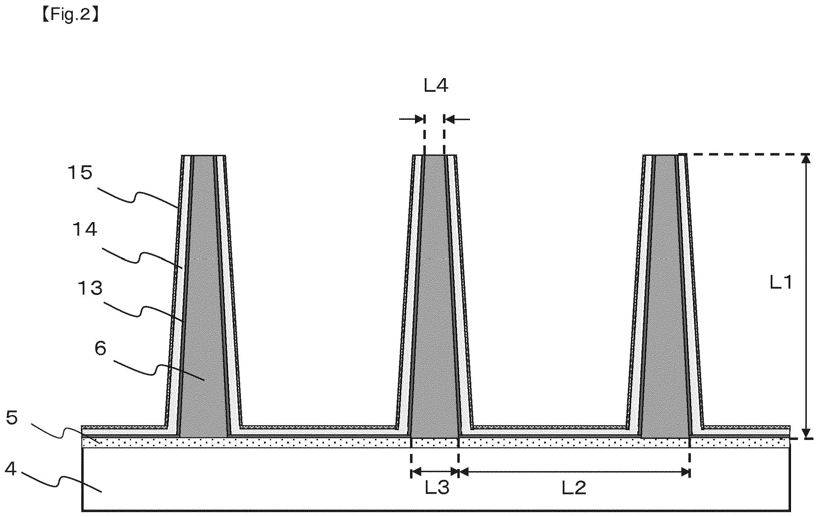

Fig. 2 is a sectional view schematically showing a configuration of the scintillator panel. The scintillator panel 2 includes: a substrate 4; a buffer layer 5 formed on the substrate 4; barrier ribs 6 for forming separated spaces, i.e. cells, on the buffer layer 5; light shielding layers 13 formed on surfaces of the barrier ribs 6 and areas of the substrate 4, which are not provided with the barrier ribs; reflecting layers 14; protective layers 15; and phosphor layers 7 including a composition containing an inorganic material, the composition being packed in the spaces (cells) separated by the barrier ribs 6. The output substrate 3 in Fig. 1 includes on a substrate 11 a photoelectric conversion layer 9 and an output layer 10 in which pixels each composed of a photoelectric conversion element and a TFT are two-dimensionally formed. The radiation detector 1 is obtained by bonding or adhering the light emitting surface of the scintillator panel 2 and the photoelectric conversion layer 9 of the output substrate 3 to each other with a barrier layer 8 interposed therebetween, the barrier rib layer 8 being composed of a polyimide resin etc. When light emitted from the phosphor layer 7 arrives at the photoelectric conversion layer 9, photoelectric conversion is performed at the photoelectric conversion layer 9, and an electric signal is outputted through the output layer 10. In the scintillator panel according to the present invention, the cells are separated by barrier ribs, and therefore when the size and pitch of the pixel of the photoelectric conversion element disposed in a grid-like shape are made equal to the size and pitch of the cell of the scintillator panel, each pixel of the photoelectric conversion element can be associated with each cell of the scintillator panel.

The substrate as one of the constituent elements of the scintillator panel is a flat-shaped support on which barrier ribs are placed. The material of the substrate is, for example, a polymer, a ceramic, a semiconductor, a metal or glass, which is permeable to a radiation. The polymer compound is, for example, polyester, cellulose acetate, polyamide, polyimide, polycarbonate or a carbon fiber-reinforced resin. The ceramic is, for example, alumina, aluminum nitride, mullite, steatite, silicon nitride or silicon carbide. The semiconductor is, for example, silicon, germanium, gallium arsenide, gallium phosphorus or gallium nitrogen. The metal is, for example, aluminum, iron, copper or metal oxides. The glass is, for example, quartz, borosilicate glass or chemically reinforced glass.

The thickness of the substrate is preferably 1 mm or less for suppressing absorption of a radiation by the substrate.

The reflectance of the substrate is preferably 90% or more. When the reflectance is 90% or more, the luminance of the scintillator panel is improved. The substrate having a reflectance of 90% or more is, for example, a white PET film that is used as a reflecting plate in a liquid crystal display. Here, the reflectance is a SCI reflectance at a wavelength of 530 nm, which is measured using a spectral colorimeter (e.g. CM-2600d; manufactured by KONICA MINOLTA, INC.).

Fig. 2 is a sectional view schematically showing the configuration of the scintillator panel manufactured by the manufacturing method according to the present invention.

The height L1 of the barrier rib 6 is preferably 100 to 3000 µm, more preferably 160 to 1000 µm. When the height L1 is more than 3000 µm, light emitted by the phosphor may be markedly absorbed, leading to a reduction in luminance. On the other hand, when the height L1 is less than 100 µm, the amount of the composition containing a phosphor, which can be packed, may decrease, leading to a reduction in luminance of the scintillator panel.

The interval L2 between adjacent barrier ribs is preferably 30 to 1000 µm. When the interval L2 is less than 30 µm, it is apt to be difficult to pack the composition containing a phosphor in the cell. On the other hand, when the interval L2 is more than 1000 µm, the sharpness of the scintillator panel may be reduced.

The bottom part width L3 of the barrier rib is preferably 5 to 150 µm, more preferably 10 to 100 µm. When the bottom part width L3 is less than 5 µm, pattern defects easily occur even when the applied pressure is an isostatic pressure. On the other hand, when the bottom part width L3 is more than 150 µm, the amount of the composition containing a phosphor, which can be packed, may decrease, leading to a reduction in luminance of the scintillator panel.

The top part width L4 of the barrier rib is preferably 5 to 80 µm. When the top part width L4 is less than 5 µm, the strength of the barrier rib is reduced, so that pattern defects easily occur. On the other hand, when the top part width L4 is more than 80 µm, a region where light emitted by the phosphor can be extracted may be narrowed, leading to a reduction in luminance of the scintillator panel. The top part width L4 is preferably equal to or smaller than the bottom part width L3. This is because when the cell has a shape in which the opening is wider than the bottom part, packing is facilitated. Here, L3 is the width of the barrier rib at a contact part between the barrier rib and the substrate. L4 is the width of the topmost part of the barrier rib.

The aspect ratio (L1/L3) of the height L1 of the barrier rib to the bottom part width L3 of the barrier rib is preferably 1.0 to 50.0. When the aspect ratio (L1/L3) of the barrier rib increases, a space per pixel separated by the barrier rib becomes wider, so that a larger amount of the composition containing a phosphor can be packed in the space.

The aspect ratio (L1/L2) of the height L1 of the barrier rib to the interval L2 between barrier ribs is preferably 0.5 to 5.0, more preferably 1.0 to 5.0. When the aspect ratio (L1/L2) of the barrier rib increases, a pixel is finely separated, and a larger amount of the composition containing a phosphor can be packed in a space per pixel.

The height L1 of the barrier rib and the interval L2 between adjacent barrier ribs can be measured in the following manner: a cross-section vertical to a substrate is exposed by a polishing apparatus such as a cross section polisher, and the cross-section is observed with a scanning electron microscope (e.g. S2400; manufactured by Hitachi, Ltd.).

Preferably, the barrier rib is composed of an inorganic material for improving the strength and heat resistance of the barrier rib. The term "composed of an inorganic material" does not exclude existence of components other than an inorganic substance in the strict sense, and existence of components other than an inorganic substance, such as impurities contained in the inorganic substance serving as a raw material, and impurities entering during manufacturing of the barrier rib, is acceptable.

The Young's modulus of the barrier rib is preferably 10 GPa or more. When the Young's modulus is 10 GPa or more, the strength of the barrier rib is improved, so that the barrier rib is harder to damage at the time of packing the composition containing a phosphor. The Young's modulus of the barrier rib can be measured by a nanoindentation method that is a micro-region-push-in method.

Preferably, the barrier rib contains glass as a main component. Here, the glass is an inorganic amorphous solid containing a silicate. When the main component of the barrier rib is glass, the strength and high heat resistance of the barrier rib are improved, so that the barrier rib is harder to damage at the time of packing the composition containing a phosphor. "Containing glass as a main component" means that glass constitutes 50 to 100% by mass of materials for forming the barrier rib.

Preferably, the buffer layer 5 is formed between the substrate 4 and the barrier rib 6. When the buffer layer is formed, the barrier rib can be stably formed. When the buffer layer is formed of glass, it is preferable to use glass having a composition identical to that of the barrier rib for suppressing strain by heat.

Preferably, the scintillator panel according to the present invention includes the light shielding layer 13, which contains a metal, between the barrier rib 6 and the phosphor layer 7. When the scintillator panel includes the light shielding layer, which contains a metal, between the barrier rib and the phosphor layer, leakage of scintillation light to the adjacent cell can be inhibited. Preferably, the light shielding layer contains a metal as a main component. "Containing a metal as a main component" means that the ratio of a metal to the light shielding layer is 50% by volume or more. The method for forming the light shielding layer is, for example, a vacuum deposition method such as a vacuum vapor deposition method, a sputtering method or a CVD method, a plating method, or a spraying method using a spray. In each method, a reflecting layer can be formed only in cells by using a mask. The metal contained in the light shielding layer is, for example, aluminum, chromium, gold, silver, copper, nickel, tungsten, molybdenum or lead. The average thickness of the light shielding layer is preferably 0.02 to 1 µm. When the average thickness of the light shielding layer is less than 0.02 µm, the effect of suppressing leakage of scintillation light and the effect of absorbing an X ray are apt to be insufficient. On the other hand, when the average thickness of the light shielding layer is more than 1 µm, the volume of the phosphor layer may be insufficient, leading to a reduction in luminance of the scintillator panel.

Here, the average thickness of the light shielding layer is a value obtained by dividing the area of 10 light shielding layers, which are randomly selected on a cross-section of the scintillator panel vertical to the substrate, by the formation length of the light shielding layer, and the formation length of the light shielding layer is a total of the lengths of the portions where the light shielding layer and the under-layer thereof (barrier rib etc.) are in contact with each other on the cross-sections of the 10 cells. More specifically, the average thickness of the light shielding layer can be calculated by passing through a process in which a cross-section of the scintillator panel vertical to the substrate is exposed by a polishing apparatus, the cross-section is observed with a scanning electron microscope, and image processing is performed.

Preferably, the scintillator panel according to the present invention includes the reflecting layer 14, which contains a metal oxide, between the barrier rib 6 and the phosphor layer 7 containing an inorganic material. Here, "including the reflecting layer between the barrier rib and the phosphor layer" means, for example, a state in which the reflecting layer is formed on surfaces of the substrate and the barrier rib, which are in contact with the phosphor layer. Preferably, the reflecting layer contains a metal oxide as a main component. "Containing a metal oxide as a main component" means that the ratio of a metal oxide to the reflecting layer is 50% by volume or more. When the scintillator panel includes the reflecting layer, which contains a metal oxide, between the barrier rib and the phosphor layer, the reflectance of each of the substrate and the barrier rib placed on the substrate can be made suitable.

The method for forming the reflecting layer is, for example, a vacuum deposition method such as a vacuum vapor deposition method, a sputtering method or a CVD method, a plating method, a spraying method using a spray, or a screen printing method. In each method, a reflecting layer can be formed only in cells by using a mask. In the case of screen printing, a reflecting layer paste may be packed only in cells by pattern printing, or a reflecting layer paste may be applied to the whole surface including the top parts of the barrier ribs, followed by removing the reflecting layer paste at the top parts of the barrier ribs by a squeegee.

Further, in this case, the composition containing the above-mentioned metal oxide may be packed under an isostatic pressure, and then fired to form the reflecting layer. When the composition is packed under an isostatic pressure, not only damage to the barrier ribs can be suppressed, but also a film can be densely formed under a high pressure, resulting in improvement of the reflectance of the reflecting layer. The average thickness of the reflecting layer is preferably 5 to 20 µm. The average thickness of the reflecting layer can be calculated by the same method as that used for calculating the average thickness of the light shielding layer. When the average thickness of the reflecting layer is less than 5 µm, the reflectance may be insufficient. On the other hand, when the average thickness of the reflecting layer is more than 20 µm, the volume of the phosphor layer may be insufficient, leading to a reduction in luminance of the scintillator panel. The metal oxide contained in the reflecting layer is preferably a compound selected from the group consisting of titanium oxide, zirconium oxide, aluminum oxide and zinc oxide for achieving a more preferred reflectance. Preferably, the reflecting layer formed of such a metal oxide has a suitable reflectance.

Preferably, the protective layer 15 is formed so that the light shielding layer 13 and the reflecting layer 14 do not fall off at the time when the composition containing an inorganic material such as a phosphor is packed into cells under an isostatic pressure. When the light shielding layer 13 and the protective layer 15 are formed, the protective layer is formed between the light shielding layer 13 and the phosphor layer 7 after formation of the light shielding layer. When the reflecting layer 14 and the protective layer 15 are formed, the protective layer is formed between the reflecting layer 14 and the phosphor layer 7 after formation of the reflecting layer. When all of the light shielding layer 13, the reflecting layer 14 and the protective layer 15 are formed, it is preferable to form the light shielding layer, the reflecting layer and the protective layer in this order. The material of the protective layer is, for example, a substance which is dense and strong even when being thin and which has low reactivity, such as glass, SiO₂ or resin. When a large thermal load is applied in a post-treatment step, it is preferable to use an inorganic substance such as glass or SiO₂. On the other hand, in the case of an organic substance, polyparaxylylene as a resin is more preferable because it has low reactivity.

The method for forming the protective layer is, for example, a vacuum deposition method, a plating method and a spraying method, and a vacuum deposition method is preferable for forming a denser film. When the thickness of the film is large, the amount of the composition containing an inorganic material, which is packed in cells, decreases, and therefore it is preferable that the film is formed in the smallest thickness within such a range that the light shielding layer and the reflecting layer do not fall off. In the case of polyparaxylylene, it is preferable that the film is formed in a thickness of 1 to 5 µm.

As a method for forming the barrier rib, a known method can be used, but a photosensitive paste method is preferable because shape control is easy.

For example, barrier ribs containing glass as a main component can be formed through an application step of applying a photosensitive paste, contains a glass powder, to a surface of a substrate to obtain an applied film; a pattern forming step of exposing and developing the applied film to obtain a pre-firing pattern of the barrier rib; and a firing step of firing a pattern to obtain a barrier rib pattern. For manufacturing barrier ribs containing glass as a main component, a glass powder should constitute 50 to 100% by mass of 50 to 100% by mass of inorganic components in the glass powder-containing paste that is used in the application step.

The glass powder contained in the glass powder-containing paste is preferably a powder of glass that is softened at a firing temperature, more preferably a powder of low-softening-point glass having a softening temperature of 700°C or lower.

The softening temperature can be determined by extrapolating a heat absorption end temperature at an endothermic peak by a tangent method from a DTA curve obtained by measuring a sample using a differential thermal analyzer (e.g. Differential Thermal Balance TG8120; manufactured by Rigaku Corporation). More specifically, first an inorganic powder as a measurement sample is measured with the temperature elevated at a rate of 20°C/minute from room temperature using a differential thermal analyzer, so that a DTA curve is obtained. In this measurement, an alumina powder is used as a standard sample. From the obtained DTA curve, a softening point Ts is determined by extrapolating a heat absorption end temperature at an endothermic peak by a tangent method. The softening point Ts can be defined as a softening temperature.

For obtaining low-softening-point glass, a metal oxide selected from the group consisting of lead oxide, bismuth oxide, zinc oxide and an oxide of an alkali metal, each of which is a compound effective for lowering the softening point of glass, can be used, but it is preferable to adjust the softening temperature of glass using an oxide of an alkali metal. Here, the alkali metal is a metal selected from the group consisting of lithium, sodium and potassium.

The ratio of the alkali metal oxide to the low-softening-point glass is preferably 2 to 20% by mass. When the ratio of the alkali metal oxide is less than 2% by mass, the softening temperature increases, and thus it is necessary to carry out the firing step at a high temperature, so that defects easily occur in barrier ribs. On the other hand, when the ratio of the alkali metal oxide is more than 20% by mass, the viscosity of glass excessively decreases in the firing step, so that the shape of the resulting grid-like post-firing pattern is easily strained.

Preferably, the low-softening-point glass contains 3 to 10% by mass of zinc oxide for the glass to have an optimum viscosity at a high temperature. When the ratio of zinc oxide to the low-softening-point glass is less than 3% by mass, the viscosity at a high temperature increases. On the other hand, when the content of zinc oxide is more than 10% by mass, the manufacturing cost of the low-softening-point glass increases.

Preferably, the low-softening-point glass contains a metal oxide selected from the group consisting of silicon oxide, boron oxide, aluminum oxide and an oxide of an alkali earth metal for adjusting stability, crystallinity, transparency, a refractive index or thermal expansion characteristics. Here, the alkali earth metal is a metal selected from the group consisting of magnesium, potassium, barium and strontium. One example of the composition range for preferred low-softening-point glass is shown below.
Alkali metal oxide: 2 to 20% by mass
Zinc oxide: 3 to 10% by mass
Silicon oxide: 20 to 40% by mass
Boron oxide: 25 to 40% by mass
Aluminum oxide: 10 to 30% by mass
Alkali earth metal oxide: 5 to 15% by mass

The particle size of an inorganic powder including a glass powder can be measured using a particle size distribution analyzer (e.g. MT3300; manufactured by NIKKISO Co., Ltd.). More specifically, an inorganic powder is added in a water-filled sample chamber of a particle size distribution analyzer, and subjected to an ultrasonic treatment for 300 seconds, and the particle size of the inorganic powder is then measured.

The 50%-volume average particle size (hereinafter, referred to as "D50") of the low-softening-point glass powder is preferably 1.0 to 4.0 µm. When the volume average particle size D50 is less than 1.0 µm, the glass powder is aggregated, and thus uniform dispersibility is no longer obtained, so that flow stability of the paste is deteriorated. On the other hand, when the volume average particle size D50 is more than 4.0 µm, the surface irregularity of a post-firing pattern obtained in the firing step becomes larger, so that the barrier rib may be easily broken later.

The glass powder-containing paste may contain, in addition to low-softening-point glass, high-softening-point glass having a softening temperature of 700°C or higher, or ceramic particles such as those of silicon oxide, aluminum oxide, titanium oxide or zirconium oxide as a filler for control of the shrinkage ratio of a grid-like pattern in the firing step, and retention of the shape of the barrier rib that is finally obtained. The ratio of the filler to all the inorganic components is preferably 50% by mass or less for preventing a reduction in strength of the barrier rib due to hindrance of sintering of the glass powder. The volume average particle size D50 is preferably the same as that of the low-softening-point glass powder.

In a photosensitive glass powder-containing paste, the refractive index n1 of the glass powder and the refractive index n2 of the organic component satisfy the relationship of preferably -0.1 < n1 - n2 < 0.1, more preferably -0.01 ≤ n1 - n2 ≤ 0.01, still more preferably -0.005 ≤ n1 - n2 ≤ 0.005 for suppressing light scattering during exposure to form a precise pattern. The refractive index of the glass powder can be appropriately adjusted according to the composition of a metal oxide contained in the glass powder.

The refractive index of the glass powder can be measured by a Becke line detection method. The refractive index of the organic component can be determined by measuring a coating film composed of the organic component by ellipsometry. More specifically, the refractive index (ng) to light having a wavelength of 436 nm (g-ray) at 25°C can be defined as n1 for the glass powder and n2 for the organic component.

The photosensitive organic component contained in the photosensitive glass powder-containing paste is, for example, a photosensitive monomer, a photosensitive oligomer or a photosensitive polymer. Here, the photosensitive monomer, photosensitive oligomer or photosensitive polymer is a monomer, oligomer of polymer which causes a reaction such as photo-crosslinking or photo-polymerization to change its chemical structure when irradiated with active light.

The photosensitive monomer is preferably a compound having an active carbon-carbon unsaturated double bond. The compound is, for example, a compound having a vinyl group, an acryloyl group, a methacryloyl group or an acrylamide group, and a polyfunctional acrylate compound or a polyfunctional methacrylate compound is preferable for increasing the density of photo-crosslinking to form a precise pattern.

The photosensitive oligomer or photosensitive polymer is an oligomer or polymer having an active carbon-carbon unsaturated double bond and having a carboxyl group. The oligomer or polymer is obtained by, for example, a carboxyl group-containing monomer such as acrylic acid, methacrylic acid, itaconic acid, crotonic acid, maleic acid, fumaric acid, vinyl acetic acid or an acid anhydride thereof, a methacrylic acid ester, an acrylic acid ester, styrene, acrylonitrile, vinyl acetate or 2-hydroxy acrylate. The method for introducing an active carbon-carbon unsaturated double bond into an oligomer or polymer is, for example, a method in which chloride acrylate, chloride methacrylate, allyl chloride, an ethylenically unsaturated compound having a glycidyl group or an isocyanate group, or a carboxylic acid such as maleic acid is reacted with a mercapto group, an amino group, a hydroxyl group or a carboxyl group in the oligomer or polymer.

By using a photosensitive monomer or photosensitive oligomer having a urethan bond, a glass powder-containing paste which is capable of relaxing stress in the initial stage of the firing step and which hardly causes damage to a pattern in the firing step.

The photosensitive glass powder-containing paste may contain a photo-polymerization initiator as necessary. Here, the photo-polymerization initiator is a compound which generates a radical when irradiated with active light. The photo-polymerization initiator is, for example, benzophenon, methyl o-benzoylbenzoate, 4,4-bis(dimethylamino)benzophenone, 4,4-bis(diethylamino)benzophenone, 4,4-dichlorobenzophenone, 4-benzoyl-4-methyldiphenylketone, dibenzylketone, fluorenone, 2,2-dimethoxy-2-phenylacetophenone, 2-hydroxy-2-methylpropiophenone, thioxanthone, 2-methylthioxanthone, 2-chlorothioxanthone, 2-isopropylthioxanthone, diethylthioxanthone, benzyl, benzyl methoxyethyl acetal, benzoin, benzoin methyl ether, benzoin butyl ether, anthraquinone, 2-t-butylanthraquinone, anthrone, benzanthrone, dibenzosuberone, methylene anthrone, 4-azidebenzalacetophenone, 2,6-bis(p-azidebenzylidene)cyclohexanone, 2,6-bis(p-azidebenzylidene)-4-methylcyclohexanone, 1-phenyl-1,2-butadione-2-(O-methoxycarbonyl)oxime, 1-phenyl-1,2-propanedione-2-(O-ethoxycarbonyl)oxime, 1,3-diphenylpropanetrione-2-(O-ethoxycarbonyl)oxime, 1-phenyl-3-ethoxypropanetrione-2-(O-benzoyl)oxime, Michler's ketone, 2-methyl-1-[4-(methylthio)phenyl]-2-morpholino-1-propanone, 2-benzyl-2-dimethylamino-1-(4-morpholinophenyl)butanone-1, naphthalenesulfonyl chloride, N-phenylthioacridone, benzthiazole disulfide, triphenylwholphin, or a combination of a photo-reducing dye such as eosine or methylene blue and a reducing agent such as ascorbic acid or triethanolamine.

When the photosensitive glass powder-containing paste contains a polymer having a carboxyl group as a photosensitive polymer, solubility in an alkali aqueous solution during development is improved. The acid value of the polymer having a carboxyl group is preferably 50 to 150 mg KOH/g. When the acid value is 150 mg KOH/g or less, the development margin is widened. On the other hand, when the acid value is 50 mg KOH/g or more, solubility in an alkali aqueous solution is not reduced, and a fine pattern can be obtained.

The photosensitive glass powder-containing paste can be obtained by blending various kinds of components so as to achieve a predetermined composition, and then homogeneously mixing and dispersing the blend by three rollers or a kneader.

The viscosity of the photosensitive glass powder-containing paste can be appropriately adjusted according to the addition ratio of an inorganic powder, a thickener, an organic solvent, a polymerization inhibitor, a plasticizer, a precipitation preventive agent or the like, but it is preferably in the range of 2 to 200 Pa·s. For example, the viscosity is preferably 2 to 5 Pa·s when the photosensitive glass powder-containing paste is applied to a substrate by a spin coating method, and the viscosity is preferably 10 to 50 Pa·s when the photosensitive glass powder-containing paste is applied to a substrate by a blade coater method or a die coater method. When the photosensitive glass powder-containing paste is applied by a screen printing method once to obtain an applied film having a thickness of 10 to 20 µm, the viscosity is preferably 50 to 200 Pa·s.

The application step is a step of applying the glass powder-containing paste to the whole or a part of a surface of a substrate to obtain an applied film. As the substrate, a support having high heat resistance, such as a glass plate or a ceramic plate, can be used. The method for applying the glass powder-containing paste is, for example, a screen printing method, a bar coater, a roll coater, a die coater or a blade coater. The thickness of the resulting applied film can be adjusted according to the number of times of application, the mesh size of a screen, the viscosity of the paste, or the like.

The pattern forming step may include, for example, an exposure step of exposing the applied film obtained in the application step, through a photomask having a predetermined opening, and a development step of dissolving and removing a portion of the post-exposure applied film, which is soluble in a developer.

The exposure step is a step of photo-curing a necessary portion of the applied film by exposure or photo-decomposing an unnecessary portion of the applied film, so that an arbitrary portion of the applied film is soluble in a developer. The development step is a step of dissolving and removing a portion of the post-exposure applied film, which is soluble in a developer, with the developer to obtain a grid-like pre-firing pattern in which only a necessary portion remains.

In the exposure step, an arbitrary pattern may be directly drawn with laser light etc. without using a photomask. The exposure apparatus is, for example, a proximity exposure machine. The active light to be applied in the exposure step is, for example, near infrared light, visible light or ultraviolet light, and ultraviolet light is preferable. The light source is, for example, a low-pressure mercury lamp, a high-pressure mercury lamp, an ultra-high-pressure mercury lamp, a halogen lamp or a bactericidal lamp, and an ultra-high-pressure mercury lamp is preferable. Exposure conditions vary depending on the thickness of the applied film, but commonly the applied film is exposed for 0.01 to 30 minutes using an ultra-high-pressure mercury lamp with an output of 1 to 100 mW/cm2.

The method for development in the development step is, for example, an immersion method, a spray method or a brush method. As the developer, a solvent capable of dissolving an unnecessary portion of the post-exposure applied film may be appropriately selected, but an aqueous solution containing water as a main component is preferable. For example, when the glass powder-containing paste contains a polymer having a carboxyl group, an alkali aqueous solution can be selected as the developer. The alkali aqueous solution is, for example, an inorganic alkali aqueous solution such as that of sodium hydroxide, sodium carbonate or potassium hydroxide, or an organic alkali aqueous solution such as that of tetramethylammonium hydroxide, trimethylbenzylammonium hydroxide or diethanolamine, and an organic alkali aqueous solution is preferable because it is easily removed in the firing step. The concentration of the alkali aqueous solution is preferably 0.05 to 5% by mass, more preferably 0.1 to 1% by mass. When the alkali concentration is less than 0.05% by mass, it may be unable to sufficiently remove an unnecessary portion of the post-exposure applied film. On the other hand, when the alkali concentration is more than 5% by mass, the grid-like pre-firing pattern may be peeled or corroded. The development temperature is preferably 20 to 50°C for facilitating process control.

For forming a pattern by exposure and development, the glass powder-containing paste to be applied in the application step should be photosensitive. In other words, the glass powder-containing paste should contain a photosensitive organic component. The ratio of the organic component to the photosensitive glass powder-containing paste is preferably 30 to 80% by mass, more preferably 40 to 70% by mass. When the ratio of the organic component is less than 30% by mass, not only dispersibility of the inorganic component in the paste is deteriorated, so that defect easily occur in the firing step, but also the viscosity of the paste increases, so that coatability is deteriorated, and further stability of the paste is easily deteriorated. On the other hand, when the ratio of the organic component is more than 80% by mass, the shrinkage ratio of the grid-like pattern in the firing step increases, so that defects easily occur.

Preferably, the glass powder contained in the photosensitive glass powder-containing paste has a softening temperature of 480°C or higher for almost completely removing the organic component in the firing step to secure the strength of the barrier rib that is finally obtained. When the softening temperature is lower than 480°C, there is the possibility that the glass powder is softened before the organic component is sufficiently removed in the firing step, so that the organic component remains in glass after sintering, and induces coloring of the barrier rib, leading to a reduction in luminance of the scintillator panel.

The firing step is a step of firing the grid-like pre-firing pattern, which is obtained in the pattern forming step, to dissolve and remove the organic component contained in the glass powder-containing paste, and softening and sintering the glass powder to obtain a grid-like post-firing pattern, i.e. the barrier rib. Firing conditions vary depending on the composition of the glass powder-containing paste and the type of the substrate, and firing can be performed in a firing furnace in an atmosphere of, for example, air, nitrogen or hydrogen. The firing furnace is, for example, a batch-type firing furnace or a belt-type continuous firing furnace. The temperature of firing is preferably 500 to 1000°C, more preferably 500 to 800°C, still more preferably 500 to 700°C. When the firing temperature is lower than 500°C, the organic component is not sufficiently decomposed and removed. On the other hand, the firing temperature is higher than 1000°C, the substrate that can be used is limited to a ceramic plate etc. having high heat resistance. The firing time is preferably 10 to 60 minutes.

For the thus-obtained substrate having barrier ribs, a phosphor is packed into cells by the foregoing packing method to obtain the scintillator panel according to the present invention.

### EXAMPLES

The present invention will be described in detail below by way of examples and comparative examples, but the present invention is not limited to these examples.

### (Raw materials of glass powder-containing barrier rib paste)

Raw materials used for preparation of a photosensitive glass powder-containing paste are as follows.
Photosensitive monomer M-1: trimethylolpropane triacrylate
Photosensitive monomer M-2: tetrapropylene glycol dimethacrylate
Photosensitive polymer: polymer obtained by addition reaction of 0.4 equivalents of glycidyl methacrylate with a carboxyl group of copolymer of methacrylic acid/methyl
methacrylate/styrene at a mass ratio of 40 : 40 : 30 (mass average molecular weight: 43000; acid value: 100).
Photo-polymerization initiator:
   2-benzyl-2-dimethylamino-1-(4-morpholinophenyl)butano ne-1(IC369; manufactured by BASF SE).
Polymerization inhibitor:
   1,6-hexanediol-bis[(3,5-di-t-butyl-4-hydroxyphenyl)pr opionate]).
Ultraviolet ray absorber solution: 0.3 mass% γ-butyrolactone solution of Sudan IV (manufactured by TOKYO OHKA KOGYO Co., Ltd.).
Viscosity modifier: FLOWNON EC121 (manufactured by KYOEISHA CHEMICAL Co., LTD).
Solvent:γ-butyrolactone (manufactured by Mitsubishi Chemical Corporation).
Low-softening-point glass powder: SiO₂: 27% by mass, B₂0₃: 31% by mass, ZnO: 6% by mass, Li₂O 7% by mass, MgO: 2% by mass, CaO: 2% by mass, BaO: 2% by mass, Al₂O₃: 23% by mass, refractive index (ng): 1.56, glass softening temperature; 588°C, thermal expansion coefficient: 70 × 10⁻⁷ (K⁻¹), average particle size: 2.3 µm.
High-softening-point glass powder: SiO₂ 30% by mass, B₂O₃: 31% by mass, ZnO: 6% by mass, MgO: 2% by mass, CaO: 2% by mass, BaO: 2% by mass, Al₂O₃: 27% by mass, refractive index (ng): 1.55, softening temperature; 790°C, thermal expansion coefficient: 32 × 10⁻⁷ (K⁻¹), average particle size: 2.3 µm.

### (Preparation of glass powder-containing barrier rib paste)

4 parts by mass of a photosensitive monomer M-1, 6 parts by mass of a photosensitive monomer M-2, 24 parts by mass of a photosensitive polymer, 6 parts by mass of a photo-polymerization initiator, 0.2 parts by mass of a polymerization inhibitor and 12.8 parts by mass of an ultraviolet ray absorber solution were heated and dissolved in 38 parts by mass of a solvent at a temperature of 80°C. The obtained solution was cooled, and 9 parts by mass of a viscosity modifier was then added to obtain an organic solution 1. The obtained organic solution 1 was applied to a glass plate, and dried to obtain an organic coating film. The organic coating film had a refractive index (ng) of 1.555.

To 50 parts by mass of the organic solution 1 were added 40 parts by mass of a low-softening-point glass powder and 10 parts by mass of a high-softening-point glass powder, and the mixture was then kneaded by a three-roller kneader to obtain a glass powder-containing paste.

### (Raw materials of reflecting layer paste)

Raw materials used for preparation of a reflecting layer paste are as follows.
Filler: titanium oxide (manufactured by Ishihara Sangyo Kaisha, Ltd.).
Binder solution: mixed solution of 5% by mass of ethyl cellulose (manufactured by The Dow Chemical Company) and 95% by mass of terpineol (Nippon Terpene Chemicals, Inc.).
Monomer: mixture of 30% by mass of dipentaerythritol pentaacrylate and 70% by mass of dipentaerythritol hexaacrylate (each manufactured by Toagosei Company, Limited).
Polymerization initiator:
   1,1'-azobis(cyclohexane-1-carbonitrile) (V-40; manufactured by Wako Pure Chemical Industries, Ltd.).

### (Preparation of reflecting layer paste)

50 parts by mass of a filler, 45 parts by mass of a binder solution, 4.5 parts by mass of a monomer and 1.5 parts by mass of a polymerization initiator were kneaded by a three-roller kneader to obtain a reflecting layer paste.

### (Raw materials of buffer layer paste)

Raw materials used for preparation of a buffer layer paste are as follows.
Filler: silica (manufactured by Admatechs). Low-softening-point glass powder: the same glass powder as in the glass powder-containing barrier rib paste is used.
Binder solution: mixed solution of 5% by mass of ethyl cellulose (manufactured by The Dow Chemical Company) and 95% by mass of terpineol (Nippon Terpene Chemicals, Inc.).
Monomer: mixture of 30% by mass of dipentaerythritol pentaacrylate and 70% by mass of dipentaerythritol hexaacrylate (each manufactured by Toagosei Company, Limited).
Polymerization initiator:
   1,1'-azobis(cyclohexane-1-carbonitrile) (V-40; manufactured by Wako Pure Chemical Industries, Ltd.).

### (Preparation of buffer layer paste)

10 parts by mass of a filler, 40 parts by mass of low-softening-point glass, 30 parts by mass of a binder solution, 18 parts by mass of a monomer and 2 parts by mass of a polymerization initiator were kneaded by a three-roller kneader to obtain a buffer layer paste.

### (Formation of buffer layer and barrier rib)

A soda glass plate having a size of 125 mm × 125 mm × 0.7 mm was used as a substrate. The buffer layer paste was applied to a surface of the substrate using a #300 mesh screen, and dried at 150°C for 30 minutes to obtain a buffer layer. The glass powder-containing barrier rib paste was applied onto the buffer layer by a die coater so as to achieve a thickness of 500 µm after drying, and dried to obtain a glass powder-containing paste applied film. Next, using an ultra-high-pressure, the glass powder-containing barrier rib paste applied film was exposed with an exposure amount of 500 mJ/cm² through a photomask (chromium mask having a pitch of 194 µm and a line width of 20 µm and having a grid-like opening), the photomask having an opening corresponding to a desired pattern. The applied film after exposure was developed in a 0.5 mass% ethanol amine aqueous solution, so that unexposed portion was removed to obtain a grid-like pre-firing pattern. The obtained grid-like pre-firing pattern was fired at 585°C for 15 minutes in air to form grid-like barrier ribs containing glass as a main component. The height L1 of the barrier rib was 350 µm, the interval L2 between barrier ribs was 194 µm, the bottom part width L3 of the barrier rib was 35 µm, and the top part width L4 of the barrier rib was 20 µm, and the Young's modulus of the barrier rib was 20 GPa.

### (Formation of reflecting layer)

The reflecting layer paste was applied to the surface of the obtained grid-like barrier rib, and left standing for 5 minutes, and the deposited reflecting layer paste was then scraped off by a squeegee with a hardness of 80°. Thereafter, drying was performed in hot air ovens at 80°C and 130°C for 30 minutes each to form a reflecting layer on the surface of the barrier rib and on portions where the barrier rib was not formed.

### (Raw material of composition containing inorganic material)

Raw materials used for preparation of a composition containing an inorganic material are as follows.
Inorganic material 1: press-molded film of a CsI:Tl powder (obtained by powdering a commercially available single crystal by a grinder, sieving the resulting powder through meshes, and removing coarse particles and very small particles).
Inorganic material 2: CsI:Tl (obtained by processing a commercially available single crystal into a 500 µm-thick thin film by a wire-saw).
Inorganic material 3: NaI:Tl (obtained by processing a commercially available single crystal into a 500 µm-thick thin film by a wire-saw).
Inorganic material 4: SrI₂:Eu (obtained by processing a commercially available single crystal into a 500 µm-thick thin film by a wire-saw).
Inorganic material 5: Gd₂O₂S:Tb (binder solution of a commercially available powder (manufactured by Nichia Corporation) : mixed solution of 30% by mass of ethyl cellulose and 70% by mass of benzyl alcohol).

### (Preparation of composition containing inorganic material)

For the inorganic material 1, first a rubber sheet having a thickness of about 1 mm was bored by a size larger than a packing area to form a rubber frame, the rubber frame was placed on a SUS plate, and a CsI:Tl powder (obtained by powdering a commercially available single crystal by a grinder, sieving the resulting powder through meshes, and removing coarse particles and very small particles) was disposed inside the frame, and leveled to a thickness of about 1 mm. The SUS plate, the rubber frame and the CsI : TI powder were put together in a plastic bag (Hiryu BN Type; manufactured by Shiro. Co., Ltd.) serving as a medium, and using a vacuum packaging machine (TOSPACK V-280; manufactured by TOSEI CORPORATION), the plastic bag was evacuated at a vacuum degree of -90 kPa or lower for 30 seconds, and then thermally welded to be sealed. The plastic bag was set in an isostatic pressure press apparatus (manufactured by Kobe Steel, Ltd.), an isostatic pressure was applied at an atmospheric temperature of 28°C and an initial pressure of 0.1 MPa to the surface of the plastic bag as a medium situated on the outermost side, via water as a pressure transmission medium, and the isostatic pressure was immediately raised at a rate of 100 MPa/minute. After 4 minutes, the isostatic pressure reached 200 MPa, i.e. a predetermined pressure (hereinafter, referred to as a "holding pressure"), and the isostatic pressure was then held for 5 minutes. Next, the pressure was reduced at a rate of 300 MPa/minute, and the plastic bag was taken out from the apparatus. Next, the SUS plate, the rubber frame and the CsI:TI press-molded film were taken out from the plastic bag, and the CsI:TI press-molded film was detached from the rubber frame and the SUS plate, and set as the inorganic material 1.

The inorganic materials 2 to 4 themselves were regarded as compositions containing the inorganic materials 2 to 4, respectively. For the inorganic material 5, 80% by weight of commercially available Gd₂O₂S:Tb and 20% by weight of a binder solution were weighed, thoroughly mixed by a spatula, and then kneaded by three rollers to form a paste, and the paste was set as a composition paste containing the inorganic material 5.

### (Example 1)

The composition containing the inorganic material 2 (i.e. inorganic material 2 itself) was disposed on the opening surfaces of cells separated by barrier ribs, this was put in a plastic bag (Hiryu BN Type; manufactured by Shiro. Co., Ltd.) serving as a medium, and using a vacuum packaging machine (TOSPACK V-280; manufactured by TOSEI CORPORATION), the plastic bag was evacuated for 30 seconds, and then thermally welded to be sealed. At this time, the vacuum degree was -91 kPa. The plastic bag was set in an isostatic pressure press apparatus (manufactured by Kobe Steel, Ltd.), an isostatic pressure was applied at an atmospheric temperature of 28°C and an initial pressure of 0.1 MPa to the surface of the plastic bag as a medium situated on the outermost side, via water as a pressure transmission medium, and the isostatic pressure was immediately raised at a pressure rise rate of 100 MPa/minute. After 4 minutes, the isostatic pressure reached 100 MPa, i.e. a predetermined pressure (hereinafter, referred to as a "holding pressure"), the isostatic pressure was then held for 5 minutes, and the composition containing the inorganic material 2 was packed into the cells to prepare a scintillator panel 1. The reflecting layer was formed in a thickness of 12 µm by applying a paste by a screen printing method, then removing an excess paste at the top parts of the barrier ribs by a squeegee, and performing drying.

The prepared scintillator panel was taken out from the plastic bag as a medium, and the external appearance of the barrier ribs was observed with an optical microscope (manufactured by KEYENCE CORPORATION). The result showed that defects such as cracking and chipping did not occur.

In a scintillator panel separately prepared under the same conditions, an excess composition was removed, the scintillator panel was then cut in a direction vertical to a substrate, the cut surface was then abraded by an ion milling method to expose a cross-section vertical to the substrate, and an electrical conductivity imparting treatment (Pt coating) was performed to prepare a measurement sample. Thereafter, a cross-section image was obtained using a field emission type scanning electron microscope S-4800 (manufactured by Hitachi High-Technologies Corporation.). For the obtained image, a portion of the composition containing an inorganic material and a void portion at the cell inside were distinguished from each other by binarization, and the ratio of the composition portion was determined by image analysis to measure the packing ratio. The cell inside is a region surrounded by the barrier rib, the light shielding layer, the reflecting layer, the protective layer or the buffer layer and a line segment between the top parts of barrier ribs on the left and the light of the cell. For minimizing a measurement error, image analysis was performed for each of three randomly selected cells, the analysis results for the cells were averaged, and the average thus obtained was defined as a packing ratio of the composition containing an inorganic material.

Thereafter, a cross-section crystal orientation image was obtained by an EBSD method using JSM-6500F (manufactured by JEOL Ltd.) equipped with a DVC-type EBSD (manufactured by TSL Company). In the obtained image, analysis was performed using attached software, so that in the inorganic material, a closed boundary having an angle of 5 degrees or more in terms of a crystal orientation was detected as a grain boundary, and a range surrounded by the grain boundary was detected as a grain shape. For the detected grain shape, the maximum length diameter was determined, and whether the grain shape was longitudinal or lateral was determined.

Further, the prepared scintillator panel 1 was set in a FPD (PaxScan3030; manufactured by Varian Company) to prepare a radiation detector. The radiation detector was irradiated with an X-ray with a tube voltage of 60 kVp from the substrate side of the scintillator panel, and the amount of light emitted from the phosphor layer was detected by the FPD to obtain a luminance value of the scintillator panel. For the image sharpness MTF (modulation transfer function) of the scintillator panel 1, an intensity signal obtained from a photographed image of a short wave chart was subjected to Fourier transformation to obtain a MFT value at a space frequency of 2 mm/lp. The ratio of each of the above-mentioned luminance value and MFT value to each of the luminance value and the MFT value of a scintillator panel as described in Comparative Example 1 was determined, so that a luminance [%] and MFT [%] as described in Table 2 were obtained. The scintillator panel 1 exhibited a good luminance and MTF.

### (Examples 2 to 5)

Except that conditions for applying an isostatic pressure were changed as in Table 1, the same procedure as in Example 1 was carried out to prepare a scintillator panel, and evaluation was performed. The evaluation results are shown in Table 2.

### (Example 6)

Except that conditions for applying an isostatic pressure were changed as in Table 1 (the pressure transmission medium in the isostatic pressure press apparatus was silicon oil heated to 150°C beforehand), the same procedure as in Example 1 was carried out to prepare a scintillator panel, and evaluation was performed. The evaluation results are shown in Table 2.

### (Example 7)

Except that the medium was changed to metal foil capsule having a thickness of 100 µm (sealed by metal foil capsule sealing apparatus (Kobe Steel, Ltd.), and conditions for applying an isostatic pressure were changed as in Table 1 (the pressure transmission medium in the isostatic pressure press apparatus was an argon gas at 300°C), the same procedure as in Example 1 was carried out to prepare a scintillator panel, and evaluation was performed. The evaluation results are shown in Table 2.

### (Examples 8 to 10)

Except that the barrier rib shape was changed as in Table 1, the same procedure as in Example 1 was carried out to prepare a scintillator panel, and evaluation was performed. The evaluation results are shown in Table 2. The height L1 of the barrier rib can be adjusted by the thickness of the glass powder-containing paste, the interval L2 between barrier ribs and the top part width L4 of the barrier rib can be adjusted by the pitch and line width of a photomask, and the bottom part width L3 of the barrier rib can be adjusted by the exposure amount.

### (Examples 11 and 12)

Except that the composition containing an inorganic material was changed to a composition as shown in Table 1, the same procedure as in Example 1 was carried out to prepare a scintillator panel, and evaluation was performed. The evaluation results are shown in Table 2.

### (Example 13)

The composition containing the inorganic material 2 (i.e. inorganic material 2 itself) was disposed on the opening surfaces of cells separated by grid-like barrier ribs, this was placed on a stage of a RIP apparatus (manufactured by Kobe Steel, Ltd.), press-bonded, and evacuated for 30 seconds, an isostatic pressure was then applied under conditions as described in Table 1 to prepare a scintillator panel, and evaluation was performed. The evaluation results are shown in Table 2.

### (Example 14)

Except that the holding pressure was changed to 400 MPa, the same procedure as in Example 1 was carried out to prepare a scintillator panel, and evaluation was performed. The evaluation results are shown in Table 2.

### (Example 15)

Except that the surface layer of the barrier rib was changed as in Table 1, the same procedure as in Example 14 was carried out to prepare a scintillator panel, and evaluation was performed. The evaluation results are shown in Table 2. As the protective layer, a polyparaxylylene film was formed in a thickness of 4 µm on the reflecting layer by vapor deposition polymerization after formation of the reflecting layer.

### (Example 16)

Except that the surface layer of the barrier rib was changed as in Table 1, the same procedure as in Example 14 was carried out to prepare a scintillator panel, and evaluation was performed. The evaluation results are shown in Table 2. The light shielding layer, the reflecting layer and the protective layer were formed in this order on the cell inside surface of the barrier rib. As the light shielding layer, an aluminum film was formed in a thickness of 0.4 µm by sputtering. The reflecting layer and the protective layer were formed in the same manner as in Example 15.

### (Example 17)

Except that the composition containing an inorganic material was set as the inorganic material 1, the same procedure as in Example 14 was carried out to prepare a scintillator panel, and evaluation was performed. A thin film obtained by press-molding had higher plasticity, and was packed at a lower pressure as compared to one obtained by cutting a single crystal in the form of a thin film, and exhibited a high packing ratio of 97%. The evaluation results are shown in Table 2.

### (Example 18)

As with Example 1, the composition containing the inorganic material 2 (i.e. inorganic material 2 itself) was disposed on the opening surfaces of cells separated by barrier ribs, this was put in a plastic bag (Hiryu BN Type; manufactured by Shiro. Co., Ltd.) serving as a medium, and using a vacuum packaging machine (TOSPACK V-280; manufactured by TOSEI CORPORATION), the plastic bag was evacuated for 10 seconds, and then thermally welded to be sealed. At this time, the vacuum degree was -50 kPa. Otherwise in the same manner as in Example 14, a scintillator panel was prepared, and evaluation was performed. The evaluation results are shown in Table 2.

### (Comparative Example 1)

A paste composed of the composition containing the inorganic material 5 was applied by a screen printing method to the opening surfaces of cells separated by barrier ribs as described in Table 1, was dried at 150°C for 30 minutes. Thereafter, the inorganic material 5 at the barrier rib top parts was scraped off by a spatula to form a substrate packed with the inorganic material 5. Thereafter, evaluation was performed in the same manner as in Example 1.

### (Comparative Examples 2 and 3)

The composition containing the inorganic material 2 (i.e. inorganic material 2 itself) was disposed in the openings of cells separated by barrier ribs, and this was set on a stage of a uniaxial press machine (manufactured by Toho Press Seisakusho Ltd.). Except that rather than an isostatic pressure, a uniaxial pressure was applied vertically from above to the opening surfaces of cells under conditions as described in Table 1, the same procedure as in Example 1 was carried out to prepare a scintillator panel, and evaluation was performed. Chipping of the barrier rib and cracking of the substrate occurred over the whole surface in Comparative Example 2, and chipping of the barrier rib and cracking of the substrate partially occurred in Comparative Example 3. Thus, in these comparative examples, it was unable to measure the luminance and the MTF.

### (Comparative Example 4)

The composition containing the inorganic material 2 (i.e. inorganic material 2 itself) was disposed in the openings of cells separated by barrier ribs, and this was set on a stage of a uniaxial press machine (manufactured by Toho Press Seisakusho Ltd.). Further, the stage was heated to 150°C, and rather than an isostatic pressure, a uniaxial pressure was applied vertically from above to the opening surfaces of cells. Except that the pressure was applied under conditions as described in Table 1, the same procedure as in Example 1 was carried out to prepare a scintillator panel, and evaluation was performed. In Comparative Example 4, chipping of the barrier rib and cracking of the substrate partially occurred, and thus, it was unable to measure the luminance and the MTF.

**[Table 1]**

| | Packing conditions | | | | | | Barrier rib shape | | | Barrier rib surface layer | Packed material |
|---|---|---|---|---|---|---|---|---|---|---|---|
| | Method | Atmospheric temperature [°C] | Pressure rise rate [MPa/min] | Holding pressure [MPa] | Vacuum packaging | | Aspect ratio (L1/L3) | Bottom part width L3 [µm] | Top part width L4 [µm] | Light shielding layer Reflecting layer Protective layer | Inorganic material contained |
| | | | | | Done or not done | Vacuum degree [kPa] | | | | | |
| Example 1 | CIP | 28 | 200 | 100 | Done | -91 | 10:1 | 35 | 20 | Reflecting layer | Inorganic material 2 |
| Example 2 | CIP | 28 | 100 | 980 | Done | -91 | 10:1 | 35 | 20 | Reflecting layer | Inorganic material 2 |
| Example 3 | CIP | 28 | 100 | 10 | Done | -91 | 10:1 | 35 | 20 | Reflecting layer | Inorganic material 2 |
| Example 4 | CIP | 28 | 400 | 980 | Done | -91 | 10:1 | 35 | 20 | Reflecting layer | Inorganic material 2 |
| Example 5 | CIP | 28 | 60 | 980 | Done | -91 | 10:1 | 35 | 20 | Reflecting layer | Inorganic material 2 |
| Example 6 | WIP | 150 | 100 | 400 | Done | -91 | 10:1 | 35 | 20 | Reflecting layer | Inorganic material 2 |
| Example 7 | HIP | 300 | 100 | 400 | Done | -91 | 10:1 | 35 | 20 | Reflecting layer | Inorganic material 2 |
| Example 8 | CIP | 28 | 100 | 400 | Done | -91 | 25:1 | 10 | 10 | Reflecting layer | Inorganic material 2 |
| Example 9 | CIP | 28 | 100 | 400 | Done | -91 | 4:1 | 80 | 20 | Reflecting layer | Inorganic material 2 |
| Example 10 | CIP | 28 | 100 | 400 | Done | -91 | 10:1 | 35 | 70 | Reflecting layer | Inorganic material 2 |
| Example 11 | CIP | 28 | 100 | 400 | Done | -91 | 10:1 | 35 | 20 | Reflecting layer | Inorganic material 3 |
| Example 12 | CIP | 28 | 100 | 400 | Done | -91 | 10:1 | 35 | 20 | Reflecting layer | Inorganic material 4 |
| Example 13 | RIP | 28 | 200 | 100 | Not done | - | 10:1 | 35 | 20 | Reflecting layer | Inorganic material 2 |
| Example 14 | CIP | 28 | 100 | 400 | Done | -91 | 10:1 | 35 | 20 | Reflecting layer | Inorganic material 2 |
| Example 15 | CIP | 28 | 100 | 400 | Done | -91 | 10:1 | 35 | 20 | Reflecting layer Protective layer | Inorganic material 2 |
| Example 16 | CIP | 28 | 100 | 400 | Done | -91 | 10:1 | 35 | 20 | Light shielding layer Reflecting layer Protective layer | Inorganic material 2 |
| Example 17 | CIP | 28 | 100 | 300 | Done | -91 | 10:1 | 35 | 20 | Reflecting layer Protective layer | Inorganic material 1 |
| Example 18 | CIP | 28 | 100 | 400 | Done | -50 | 10:1 | 35 | 20 | Reflecting layer | Inorganic material 2 |
| Comparative Example 1 | Paste method | 28 | - | - | - | - | 10:1 | 35 | 20 | Reflecting layer | Inorganic material 5 |
| Comparative Example 2 | Uniaxial press | 28 | 100 | 80 | Not done | - | 10:1 | 35 | 20 | Reflecting layer | Inorganic material 2 |
| Comparative Example 3 | Uniaxial press | 28 | 10 | 80 | Not done | - | 10:1 | 35 | 20 | Reflecting layer | Inorganic material 2 |
| Comparative Example 4 | Uniaxial press | 150 | 10 | 80 | Not done | - | 10:1 | 35 | 20 | Reflecting layer | Inorganic material 2 |

**[Table 2]**

| | Evaluation of scintillator panel | | | | |
|---|---|---|---|---|---|
| | External appearance of barrier rib | Packing ratio [%] | Luminance [%] | MTF [%] | Grain shape |
| Example 1 | No defects | 93 | 133 | 136 | Longitudinal |
| Example 2 | No defects | 96 | 144 | 132 | Longitudinal |
| Example 3 | No defects | 75 | 109 | 155 | Longitudinal |
| Example 4 | No defects | 97 | 142 | 136 | Longitudinal |
| Example 5 | No defects | 93 | 117 | 150 | Longitudinal |
| Example 6 | No defects | 93 | 133 | 141 | Longitudinal |
| Example 7 | No defects | 95 | 144 | 136 | Longitudinal |
| Example 8 | No defects | 93 | 156 | 109 | Longitudinal |
| Example 9 | No defects | 93 | 111 | 164 | Longitudinal |
| Example 10 | No defects | 93 | 111 | 141 | Longitudinal |
| Example 11 | No defects | 93 | 144 | 127 | Longitudinal |
| Example 12 | No defects | 93 | 178 | 123 | Longitudinal |
| Example 13 | No defects | 90 | 122 | 132 | Longitudinal |
| Example 14 | No defects | 94 | 144 | 127 | Longitudinal |
| Example 15 | No defects | 93 | 189 | 141 | Longitudinal |
| Example 16 | No defects | 93 | 111 | 191 | Longitudinal |
| Example 17 | No defects | 97 | 200 | 141 | Longitudinal |
| Example 18 | No defects | 89 | 120 | 127 | Longitudinal |
| Comparative Example 1 | No defects | 58 | 100 | 100 | Not longitudinal |
| Comparative Example 12 | Chipped over whole surface | Measurement impossible | Measurement impossible | Measurement impossible | Measurement impossible |
| Comparative Example 3 | Partially chipped | Measurement impossible | Measurement impossible | Measurement impossible | Measurement impossible |
| Comparative Example 4 | Partially chipped | Measurement impossible | Measurement impossible | Measurement impossible | Measurement impossible |

### INDUSTRIAL APPLICABILITY

The present invention is useful as a method for manufacturing a scintillator panel which is a display member that forms a radiation detector to be used in, for example, a medical diagnosis apparatus, nondestructive inspection equipment or the like.

### DESCRIPTION OF REFERENCE SIGNS

- 1:: Radiation detector
- 2:: Scintillator panel
- 3:: Output substrate
- 4:: Substrate
- 5:: Buffer layer
- 6:: Barrier rib
- 7:: Phosphor layer
- 8:: Barrier layer
- 9:: Photoelectric conversion layer
- 10:: Output layer
- 11:: Substrate
- 12:: Power supply unit
- 13:: Light shielding layer
- 14:: Reflecting layer
- 15:: Protective layer
- 16:: Composition
- 17:: Longitudinal grain shape
- 18:: Lateral grain shape

## Claims

1. A method for manufacturing a display member, the method comprising packing a composition, which contains an inorganic material, into cells separated by barrier ribs, under an isostatic pressure.

2. The method for manufacturing a display member according to claim 1, wherein the barrier rib contains glass as a main component.

3. The method for manufacturing a display member according to claim 1 or 2, wherein the display member includes a reflecting layer between the barrier rib and the composition containing an inorganic material, and the reflecting layer contains a metal oxide as a main component.

4. The method for manufacturing a display member according to any one of claims 1 to 3, wherein the display member includes a light shielding layer between the barrier rib and the composition containing an inorganic material, and the light shielding layer contains a metal as a main component.

5. The method for manufacturing a display member according to claim 3 or 4, wherein the display member includes a protective layer between the reflecting layer and the composition containing an inorganic material or between the light shielding layer and the composition containing an inorganic material.

6. The method for manufacturing a display member according to any one of claims 1 to 5, wherein the packing of the composition containing an inorganic material, under the isostatic pressure is performed while the cells and the composition containing an inorganic material are vacuum-packaged.

7. The method for manufacturing a display member according to any one of claims 1 to 6, wherein the composition containing an inorganic material is in the form of a thin film, and the composition in the form of a thin film is disposed on the opening surfaces of the cells, and packed.

8. The method for manufacturing a display member according to claim 7, wherein the composition in the form of a thin film is obtained by press-molding the composition containing an inorganic material.

9. The method for manufacturing a display member according to claim 8, wherein the composition in the form of a thin film is obtained by performing press-molding under an isostatic pressure.

10. The method for manufacturing a display member according to claim 9, wherein the press-molding under the isostatic pressure is performed while the composition containing an inorganic material is vacuum-packaged.

11. The method for manufacturing a display member according to any one of claims 1 to 10, wherein the inorganic material contains a phosphor.

12. The method for manufacturing a display member according to 11, wherein the phosphor has plasticity.

13. The method for manufacturing a display member according to any one of claims 1 to 12, wherein the display member is a scintillator panel.

14. A display member obtained by the manufacturing method according to any one of claims 1 to 13, wherein the packing ratio of the composition containing an inorganic material, which is packed into the cells under the isostatic pressure, is 75% or more.

15. The display member according to claim 14, wherein the packing ratio of the composition containing an inorganic material, which is packed into the cells under the isostatic pressure, is 95% or more.

16. The display member according to claim 14 or 15, wherein the composition containing an inorganic material is packed in a longitudinally long shape under the isostatic pressure.
